# DEMANDE DE BREVET EUROPEEN

(11) **EP 4 202 075 A1**
(43) Date de publication de la demande: **28.06.2023**
(21) Numéro de dépôt: 21216464.4
(22) Date de dépôt: 21.12.2021
(51) Int. Cl.: C23C 14/58, C23C 14/34, C23C 14/14, C23C 14/00, C23C 14/02, A44C 27/00, C25D 7/00, G04B 37/22, G04B 19/12, G04B 45/00

(54) **PROCÉDÉ DE DÉPÔT D'UN REVÊTEMENT SUR UN SUBSTRAT**

(71) Demandeur: Omega SA, 2502 Biel/Bienne (CH)
(72) Inventeur: CURCHOD, Loïc, 1004 Lausanne (CH); SPRINGER, Simon, 3007 Berne (CH); LAUPER, Stéphane, 2016 Cortaillod (CH); ODEH, Ahmad, 1020 Renens (CH); GSTALTER, Marion, 2056 Dombresson (CH); OBERSON, Loïc, 1110 Morges (CH); KISSLING, Gregory, 2520 La Neuveville (CH)
(74) Mandataire: ICB SA

(57) **Abrégé**

L'invention concerne un procédé de dépôt d'un revêtement sur un substrat (100), ledit procédé étant caractérisé en ce qu'il comporte successivement :
- une étape de dépôt d'une couche mince intermétallique (110) sur ledit substrat (100), de sorte à obtenir une pièce d'habillage (10),
- une étape de recuit de la pièce d'habillage (10) dans une enceinte dédiée.

## Description

### Domaine technique de l'invention

L'invention relève du domaine des matériaux, et notamment des matériaux définissant l'aspect extérieur de pièces d'habillage d'horlogerie, de bijouterie, d'articles de mode, ou plus généralement d'objets divers.

Plus particulièrement, l'invention concerne un procédé de dépôt d'un revêtement sur un substrat.

### Arrière-plan technologique

Les dépôts de couches minces sous atmosphère contrôlée sont couramment utilisés dans l'industrie en général et dans les domaines horloger et bijoutier en particulier, pour réaliser des revêtements ayant des applications esthétiques et/ou techniques.

Pour les applications esthétiques, les couches minces déposées peuvent être composées de métaux nobles, tels que l'or (Au) et l'argent (Ag), ou d'alliages de métaux nobles. Ces alliages de métaux nobles sont souvent composés d'une combinaison d'or, d'argent et de cuivre (Cu), avec éventuellement des ajouts de platine (Pt) ou d'autres métaux voisins. Dans ces alliages de métaux nobles, les atomes forment des liaisons métalliques qui sont à l'origine de la couleur de l'alliage et de sa malléabilité.

Parmi les méthodes de dépôt de couches minces couramment utilisées se trouvent les méthodes de dépôt physique en phase vapeur (connues sous le sigle en langue anglaise « PVD », pour « Physical Vapor Déposition ») comprenant notamment la méthode de pulvérisation cathodique et les méthodes d'évaporation ; les méthodes de dépôt chimique en phase vapeur (connues sous le signe en langue anglaise « CVD » pour « Chemical Vapor Déposition ») ; les méthodes de dépôt de métaux par croissance galvanique ; et les méthodes de dépôt de couches minces atomiques (connues sous le sigle en langue anglaise « ALD », pour « Atomic Layer Déposition »).

Il existe en outre des composés intermétalliques, notamment de métaux nobles, offrant une palette de couleurs élargie par rapport aux alliages nobles standards précités. Par exemple, les composés intermétalliques Pt-Al jaune, Pt-Al-Cu orange ou rose, Au-AI bleu, Au-In violet.

Dans ces composés intermétalliques, les atomes forment des liaisons covalentes fortes qui sont à l'origine des couleurs particulières de ces composés, mais qui les rendent durs et cassants sous leur forme massive. Ces composés intermétalliques sont donc difficilement exploitables et effectivement peu exploités sous leur forme massive car peu malléables et difficiles à mettre en forme.

Ces composés intermétalliques peuvent néanmoins être exploités sous forme de couches plus ou moins minces en mettant en œuvre une des méthodes de dépôt de couches minces sous vide précitées.

Par exemple, ces méthodes de dépôt peuvent être mises en œuvre pour déposer des couches minces de composés intermétalliques formés à partir de métaux tels que Au, Al, Cu, In ou Pt, comme les composés AuAl₂ ou PtAl₂.

Néanmoins, les couches minces de composés intermétalliques déposées par ces méthodes sont hors équilibre thermodynamique et présentent une phase principalement amorphe qui n'a pas la couleur désirée que lesdits composés intermétalliques de mêmes compositions ont sous leur forme massive et cristalline, mais typiquement une couleur grise sans intérêt esthétique particulier.

En effet, l'état thermodynamique des composés intermétalliques, et en particulier leur cristallinité et/ou la présence de différentes phases, a un impact majeur sur leur couleur pour une composition donnée.

Une étape de recuit de la couche in situ pendant le procédé de dépôt, typiquement à 400°C, est donc mise en œuvre pour provoquer une cristallisation au moins partielle de la couche de composé intermétallique ainsi déposée et obtenir la coloration de la couche qui est propre à la phase cristalline dudit composé intermétallique pour la composition donnée.

Les couches minces de composés intermétalliques restent en pratique très peu employées dans la mesure où, bien qu'elles offrent des alternatives intéressantes en terme de choix de couleurs par rapport aux couches minces d'alliages nobles standards, la mise en œuvre de la méthode pour les déposer est longue et complexe du fait de la nécessité de réaliser un recuit in situ des couches minces.

### Résumé de l'invention

La présente invention résout les inconvénients précités.

À cet effet, l'invention concerne un procédé de dépôt d'un revêtement sur un substrat, comportant successivement :
- une étape de dépôt d'une couche mince formée d'un composé intermétallique sur ledit substrat, de sorte à obtenir une pièce d'habillage,
- une étape de recuit de la pièce d'habillage dans une enceinte dédiée.

Par rapport à l'état de l'art antérieur où le recuit s'effectue in situ pendant le dépôt de la couche mince, l'invention offre l'avantage de pouvoir traiter un grand nombre de substrats simultanément, par exemple dans un four de grande dimension, et donc de réduire le temps du procédé par pièce. Cette approche permet aussi l'utilisation de méthodes de dépôt de la couche mince qui n'autorisent pas le recuit in situ, du moins pas sans complexifier le procédé et/ou l'équipement de manière rédhibitoire.

Dans des modes particuliers de mise en œuvre, l'invention peut comporter en outre l'une ou plusieurs des caractéristiques suivantes, prises isolément ou selon toutes les combinaisons techniquement possibles.

Dans des modes particuliers de mise en œuvre, l'étape de dépôt de la couche mince intermétallique est réalisée par la mise en œuvre d'une méthode de dépôt PVD parmi la pulvérisation cathodique ou ionique, l'évaporation thermique, l'évaporation par faisceau d'électrons ou par arc, ou l'ablation par faisceau laser pulsé.

Dans des modes particuliers de mise en œuvre, le dépôt de la couche mince est réalisé à partir d'au moins une cible composée d'un alliage d'au moins deux métaux ou d'au moins deux cibles de métaux purs différents. Dans le cas de l'utilisation de cibles de métaux purs, le dépôt de la couche mince est réalisé par co-pulvérisation cathodique (connue sous le terme « co-sputtering » en langue anglaise), c'est-à-dire par pulvérisation cathodique simultanée des au moins deux cibles de métaux purs différents, le composé intermétallique se formant alors à la rencontre des au moins deux flux d'atomes sur le substrat. Les puissances appliquées sur les au moins deux cibles sont choisies de manière indépendante de sorte que les taux de pulvérisation des au moins deux différents métaux résultent en la composition de couche désirée. Néanmoins, le taux de dépôt des métaux varie en fonction de l'usure des cibles correspondantes et la composition de la couche dérive en conséquence au fur et à mesure de l'exploitation desdites cibles. Ces variations de taux de dépôt peuvent être compensées par une correction de la puissance appliquée sur chacune des cibles en fonction de leur usure, soit manuellement sur la base d'un tableau de calibration, soit automatiquement grâce à une boucle de rétroaction basée sur une mesure in situ (par exemple, une mesure spectrale de l'émission optique du plasma dans le cas de la pulvérisation cathodique).

Dans le cas de l'utilisation d'une cible alliée, la composition de ladite cible est choisie de manière à obtenir directement la composition de couche désirée sur le substrat, avec l'avantage de ne pas dépendre de l'usure de ladite cible alliée.

Dans des modes particuliers de mise en œuvre, l'étape de dépôt est réalisée de sorte que la couche mince intermétallique présente une épaisseur comprise entre 20 et 1000 nm, de préférence entre 200 et 500 nm, et plus préférentiellement de 300 nm.

Dans des modes particuliers de mise en œuvre, l'étape de recuit est réalisée par la mise en œuvre d'une opération de recuit global dans laquelle l'ensemble de la couche mince intermétallique est traité thermiquement afin de la cristalliser et lui conférer une couleur attendue.

Dans des modes particuliers de mise en œuvre, la température à laquelle est soumise la pièce d'habillage lors de l'opération de recuit global est comprise entre 200°C et 500°C, et est de préférence sensiblement égale à 300°C, pendant une durée comprise en 30 et 120 minutes, et de préférence de 60 minutes.

Dans des modes particuliers de mise en œuvre, l'étape de recuit global est réalisée dans un four conventionnel sous atmosphère ambiante, préférentiellement sous atmosphère protectrice d'un gaz inerte, i.e. l'argon (Ar), ou sous vide afin d'éviter toute interaction chimique entre la couche mince intermétallique et l'atmosphère.

Dans des modes particuliers de mise en œuvre, l'étape de recuit est réalisée par la mise en œuvre d'une opération de recuit localisé sur une zone prédéterminée de la couche mince intermétallique. On obtient ainsi un contraste de couleurs entre la zone non-recuite, amorphe et grise, et la zone recuite, cristallisée et colorée.

Dans des modes particuliers de mise en œuvre, l'étape de recuit est réalisée par la mise en œuvre de l'opération de recuit localisé à la suite de l'opération de recuit global.

Dans des modes particuliers de mise en œuvre, l'opération de recuit localisé est réalisée par le biais d'un laser dont le faisceau présente un diamètre compris entre 10 µm et 100 µm, voire entre 50 µm et 100 µm.

Dans des modes particuliers de mise en œuvre, l'opération de recuit localisé est réalisée par le biais d'un laser configuré pour émettre des impulsions dont la durée est comprise entre 4 ns et 350 ns, de fréquence variable entre 10 kHz et 1 MHz.

Dans des modes particuliers de mise en œuvre, l'opération de recuit localisé est réalisée à atmosphère ambiante, préférentiellement dans une enceinte sous atmosphère protectrice d'un gaz inerte, i.e. l'argon (Ar), ou sous vide afin d'éviter toute interaction chimique entre la couche mince intermétallique et l'atmosphère.

Dans des modes particuliers de mise en œuvre, l'étape de dépôt de la couche mince peut être précédée d'une étape de structuration de surface dans laquelle la surface du substrat est structurée, par exemple sur seulement une partie.

Dans des modes particuliers de mise en œuvre, la partie de la surface du substrat structurée correspond à la zone prédéterminée soumise à l'opération de recuit localisé, un contraste d'aspect de surface s'additionnant alors au contraste de couleur pour un effet esthétique avantageux.

Dans des modes particuliers de mise en œuvre, la structuration est réalisée sur l'ensemble de la surface du substrat qui sera couverte par la couche mince intermétallique.

Dans des modes particuliers de mise en œuvre, le procédé comprend, à la suite de l'étape de dépôt de couche mince intermétallique et de l'étape de recuit global et/ou localisé, une étape de dépôt d'une couche de protection de la couche mince intermétallique contre les agressions de l'environnement, dans laquelle la couche mince intermétallique est recouverte d'un empilement de couches minces diélectriques déposées par l'une ou plusieurs méthodes de dépôt sous vide, telles que par PVD, CVD ou ALD.

Dans des modes particuliers de mise en œuvre, les épaisseurs et compositions des couches minces diélectriques formant l'empilement de protection sont choisies de sorte à ce que les effets optiques interférentiels desdites couches minces diélectriques se compensent dans le but de conserver la couleur originale de la couche mince intermétallique.

Dans des modes particuliers de mise en œuvre, les épaisseurs et compositions des couches minces diélectriques formant l'empilement de protection sont choisies de sorte à ce que les effets optiques interférentiels desdites couches minces diélectriques modifient la couleur de la couche mince intermétallique de manière esthétiquement avantageuse, par exemple en augmentant la saturation de la couleur ou en corrigeant la teinte dans une direction choisie.

Dans des modes particuliers de mise en œuvre, la couche de protection est une couche de polymère translucide déposée par sprayage ou toute autre méthode connue de l'homme du métier.

Dans des modes particuliers de mise en œuvre, la couche de protection est une couche composite avec des combinaisons de couches polymères et diélectriques déposées par les techniques connues de l'homme du métier.

L'invention concerne également, selon un autre aspect, un composant horloger comprenant un substrat comprenant un revêtement déposé par la mise en œuvre du procédé précité.

### Brève description des figures

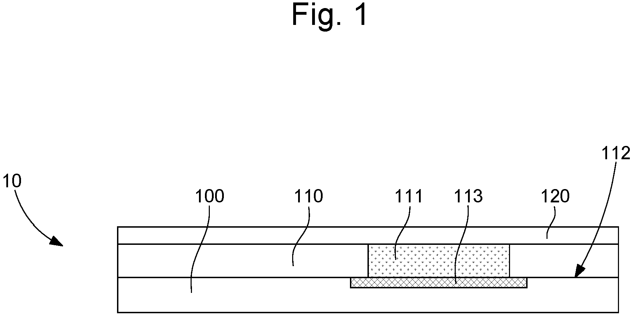

D'autres caractéristiques et avantages de l'invention apparaîtront à la lecture de la description détaillée suivante donnée à titre d'exemple nullement limitatif, en référence au dessin de la figure 1 représentant schématiquement une vue en coupe d'un composant horloger, tel qu'une pièce d'habillage, comportant un substrat comprend un revêtement déposé par la mise en œuvre d'un procédé de dépôt d'une couche intermétallique selon la présente invention.

### Description détaillée de l'invention

La présente invention concerne un procédé de dépôt d'un revêtement sur un substrat 100, ledit procédé comportant une étape de dépôt d'une couche mince intermétallique 110 sur le substrat 100 de sorte à obtenir une pièce d'habillage 10.

Le substrat 100 peut être réalisé dans tout matériau approprié, tel qu'en matériau métallique, céramique, etc.

Le procédé comporte une étape de dépôt d'une couche mince intermétallique 110 sur le substrat 100, suivie d'une étape de recuit de ladite pièce d'habillage 10 dans une enceinte dédiée.

L'étape de dépôt de la couche mince intermétallique 110 est réalisée par la mise en œuvre d'une méthode de dépôt PVD et plus particulièrement par la mise en œuvre d'une des méthodes suivantes : pulvérisation cathodique ou ionique, évaporation thermique, évaporation par faisceau d'électrons ou par arc, ou ablation par faisceau laser pulsé.

Le dépôt de la couche mince intermétallique 110 est réalisé à partir d'au moins deux cibles composées chacune d'un métal propre et/ou à partir d'au moins une cible composée d'un alliage d'au moins deux métaux.

Préférentiellement, pour simplifier la mise en œuvre de l'étape de dépôt de la couche mince intermétallique 110, celle-ci est réalisée à partir d'une cible composée d'un alliage d'au moins deux métaux. Par ailleurs, les résultats obtenus lors de tests montrent que la composition de la couche mince intermétallique 110 est plus reproductible lorsque l'étape de dépôt de la couche mince intermétallique 110 est mise en œuvre à partir d'une unique cible composée d'un alliage de métaux.

A titre d'exemple non-limitatif, les métaux utilisés sont choisis parmi le Pt, Al, Cu, In et Au, ou parmi des alliages de ces métaux.

Plus précisément, les métaux sont par exemple choisis de sorte que la couche mince intermétallique 110 comporte une combinaison intermétallique Au-AI, Au-ln, Pt-Al, ou Pt-Al-Cu.

L'étape de dépôt est réalisée de sorte que la couche mince intermétallique 110 mesure entre 20 et 1000 nm d'épaisseur, de préférence entre 200 et 500 nm, et plus préférentiellement 300 nm. Ainsi, la couche mince intermétallique 110 est avantageusement opaque et présente un bon compromis entre une épaisseur suffisamment importante pour que la couche mince intermétallique 110 soit adaptée à résister à des contraintes mécaniques qu'elle est susceptible de subir, et une épaisseur suffisamment faible pour que la consommation de métaux nobles et que la durée de dépôt de la couche mince intermétallique 110 ne soient pas trop élevées.

Le procédé de dépôt est mis en œuvre de sorte que la couche mince intermétallique 110 présente une phase amorphe suite à son dépôt.

Les paramètres de la méthode de dépôt PVD, notamment les puissances appliquées simultanément sur les différentes sources, sont choisis de sorte que la couche mince intermétallique 110 obtenue ait une composition qui présente une couleur souhaitée après l'étape de recuit.

À titre d'exemple non-limitatif, on peut déposer une couche mince intermétallique Pt-Al-Cu par co-pulvérisation cathodique à partir de 3 cibles de Pt, Al et Cu purs dont la composition est Pt 61.7%-masse, Al 18.3%-masse, Cu 20.0%-masse. En sortie de dépôt, la couche mince intermétallique est faiblement cristallisée et sa couleur est mesurée à (L*, a*, b*) = (77.5, 1.9, 2.6). Elle présente donc une couleur grise très légèrement rosée mais sans grand avantage esthétique. Après recuit dans un four à tube sous vide à 500°C pendant 2 heures, la couche se cristallise et prend une couleur mesurée à (L*, a*, b*) = (78.2, 10.8, 20.8). Elle présente alors une couleur orange-rosé très soutenue et esthétiquement avantageuse.

L'étape de recuit est avantageusement réalisée dans une enceinte dédiée, différente de l'enceinte dans laquelle est réalisé le dépôt de la couche mince intermétallique 110, c'est-à-dire différente de la chambre de déposition dans laquelle est réalisé le dépôt PVD.

L'étape de recuit a pour effet de modifier la phase de la couche mince intermétallique 110, en la faisant évoluer d'une phase amorphe à une phase cristalline.

Cette solution de la présente invention a l'avantage de pouvoir être mise en œuvre par l'utilisation d'équipements standards se trouvant dans le commerce, et de ne pas nécessiter la réalisation d'équipements spécifiques onéreux pour le recuit de la couche in situ. En outre, l'étape de recuit peut être réalisée de manière simultanée pour un grand nombre de pièces d'habillage 10 dans une même enceinte, ce qui tend à diminuer la durée de réalisation du procédé par pièce d'habillage 10 et les coûts de fabrication.

L'étape de recuit peut être réalisée par la mise en œuvre d'une opération de recuit global dans laquelle l'ensemble de la couche mince intermétallique 110, et par conséquent l'ensemble de la pièce d'habillage 10, est traité thermiquement.

Dans le cas de l'opération de recuit global, l'enceinte dédiée est formée par un four.

L'opération de recuit global est de préférence effectuée dans un four sous atmosphère contrôlée, par exemple sous argon ou azote. Alternativement, l'opération de recuit global est effectuée sous vide, la pression de travail se situant par exemple entre 10⁻⁶ et 10⁻² mbar, et de préférence à 10⁻⁴ mbar.

La température à laquelle est soumise la pièce d'habillage 10 lors de l'opération de recuit global est par exemple comprise entre 200°C et 500°C, et est de préférence sensiblement égale à 300°C. La durée de l'opération de recuit global est par exemple comprise en 30 et 120 minutes, et est de préférence de 60 minutes.

Alternativement, l'étape de recuit peut être réalisée par la mise en œuvre d'une opération de recuit localisé sur une zone prédéterminée 111 de la couche mince intermétallique 110.

L'opération de recuit localisé peut être réalisée sur la couche mince intermétallique 110 directement suite à son dépôt, c'est-à-dire lorsqu'elle présente une phase amorphe, ou à la suite de l'opération de recuit global, dans laquelle le recuit est réalisé sur l'ensemble de la pièce d'habillage 10.

Cette étape de recuit localisé a pour effet de modifier localement la couleur de la couche mince intermétallique 110, afin de générer une décoration, par exemple sous la forme d'indexes de cadrans, chiffres, logos, etc.

L'opération de recuit localisé est réalisée à l'aide d'un laser dont le faisceau peut présenter un diamètre par exemple compris entre 10 µm et 100 µm, voire entre 50 µm et 100 µm. Le déplacement du faisceau laser est avantageusement contrôlé par un système de balayage propre au laser et basé sur des axes mécaniques ou optiques apportant une importante précision de la position du point d'impact du faisceau laser sur la couche mince intermétallique 110.

Le faisceau laser a pour effet de générer localement, au niveau du point d'impact avec la couche mince intermétallique 110, une élévation locale de la température conduisant à un changement local de phase de ladite couche mince intermétallique 110, et par conséquent à un changement local de couleur.

Le faisceau laser peut être généré par un laser à impulsions nanosecondes ou à impulsions microsecondes, ou éventuellement par un laser continu.

Plus précisément, lors de l'étape de recuit localisé, le laser peut émettre des impulsions d'une durée comprise entre de 4 ns et 350 ns, de fréquence variable entre 10 kHz et 1 MHz, et pouvant atteindre une puissance moyenne de l'ordre de 40 W.

Alternativement, l'étape de recuit localisé peut aussi être mise en œuvre en utilisant des lasers à impulsions picosecondes ou femtosecondes, en utilisant l'effet d'accumulation thermique à haute cadence dans des fréquences allant de 100 à 200 kHz jusqu'à 10 MHz, ou des séries d'impulsions en rafales (connues par l'homme du métier sous le terme « bursts » en langue anglaise) espacées les unes des autres de quelques picosecondes à quelques nanosecondes.

La longueur d'onde du faisceau laser est déterminée de sorte à favoriser l'absorbance de la matière de la couche mince intermétallique 110 que le faisceau est destiné à impacter.

A titre d'exemple, le faisceau laser peut présenter une longueur d'onde comprise dans le spectre infrarouge, dans le spectre visible ou dans le spectre ultraviolet.

Lors de l'étape de recuit localisé, la variation de l'énergie des impulsions du faisceau laser, leur fréquence de répétition ainsi que leur degré de superposition conduisent à modifier la couleur de la couche intermétallique 110.

Il est ainsi possible de créer des décors multicolores ou contrastés sur la base d'un seul dépôt de couche mince intermétallique 110 de composition homogène.

Avantageusement, les étapes de dépôt et de recuit de la couche mince intermétallique peuvent être précédées d'une étape de structuration de la surface 112 du substrat 100 dans laquelle une partie de la surface 112 du substrat 100 est structurée, et est appelée « partie structurée 113 » dans la suite du texte, de sorte à générer un contraste de structure de surface sur ladite surface 112.

La partie structurée 113 de la surface 112 du substrat 100 peut correspondre à la zone prédéterminée 111 de la couche intermétallique 110 qui est soumise au traitement thermique lors de l'opération de recuit localisé. Ceci a pour effet avantageux de renforcer la différence entre l'aspect visuel de ladite zone prédéterminée 111 et celui du reste de la couche mince intermétallique 110.

Alternativement, dans une variante de réalisation de l'invention, la structuration est réalisée sur l'ensemble de la surface 112 du substrat 100.

Une telle étape de structuration de surface peut consister par exemple à polir, matifier ou satiner partiellement ou totalement la surface 112 du substrat 100, selon la variante de réalisation considérée.

Afin de faciliter l'étape de recuit localisé et de réduire l'apport local de chaleur nécessaire pour effectuer la transformation de phase de la couche mince intermétallique, la pièce d'habillage 10 peut être préchauffée à une température qui s'approche de la température de transition de phase.

Avantageusement, la couche mince intermétallique 110 obtenue après l'étape de dépôt peut être recouverte d'une couche de protection 120, par exemple formée par un empilement de couches minces diélectriques destiné à protéger la couche mince intermétallique 110 contre des agressions environnementales, lors d'une étape de dépôt ultérieure pouvant avantageusement être réalisée avec le même équipement de dépôt que celui employé pour mettre en œuvre l'étape de dépôt de la couche mince intermétallique 110. Cet empilement de couches minces diélectriques peut avoir également pour effet de modifier l'aspect visuel de la pièce d'habillage 10, par exemple d'en augmenter la brillance, et/ou de modifier la couleur de la couche intermétallique 110 par un effet interférentiel avantageux.

L'étape de dépôt d'une couche de protection 120 est avantageusement la dernière étape du procédé selon l'invention.

L'empilement de couches minces diélectriques peut être formé de différents oxydes, nitrures, oxy-nitrures, tels que le TiO₂, Al₂O₃, SiO₂, SiN, Si3N4, et peut être déposé par une méthode de dépôt ALD et/ou PVD et/ou CVD.

Alternativement, l'étape de dépôt d'une couche de protection 120 peut consister à déposer une couche de vernis, par exemple une couche de vernis polymère du type zapon ou parylène.

Globalement, si le procédé selon la présente invention comporte l'ensemble des étapes précitées, elles sont mises en œuvre successivement en débutant par l'étape de structuration de surface du substrat 100, puis l'étape de dépôt de la couche mince intermétallique 110 est réalisée, suivie de l'étape de recuit global et/ou de l'étape de recuit localisé, et enfin de l'étape de dépôt de la couche de protection 120.

L'invention propose ainsi une solution pour l'utilisation de composés intermétalliques, notamment à base de métaux nobles, offrant un large éventail de nouvelles couleurs pour des applications esthétiques dans l'horlogerie, la bijouterie et tout autre produit de luxe.

De manière plus générale, il est à noter que les modes de mise en œuvre et de réalisation considérés ci-dessus ont été décrits à titre d'exemples non limitatifs, et que d'autres variantes sont par conséquent envisageables.

## Revendications

1. Procédé de dépôt d'un revêtement sur un substrat (100), ledit procédé étant **caractérisé en ce qu'**il comporte successivement :
- une étape de dépôt d'une couche mince intermétallique (110) sur ledit substrat (100), de sorte à obtenir une pièce d'habillage (10),
- une étape de recuit de la pièce d'habillage (10) dans une enceinte dédiée.

2. Procédé selon la revendication 1, dans lequel l'étape de dépôt de la couche mince intermétallique (110) est réalisée par la mise en œuvre d'une méthode de dépôt PVD parmi la pulvérisation cathodique ou ionique, l'évaporation thermique, l'évaporation par faisceau d'électrons ou par arc, ou l'ablation par faisceau laser pulsé.

3. Procédé selon la revendication 2, dans lequel le dépôt de la couche mince est réalisé à partir d'au moins une cible composée d'un alliage d'au moins deux métaux ou d'au moins deux cibles de métaux purs différents.

4. Procédé selon l'une des revendications 1 à 3, dans lequel l'étape de dépôt est réalisée de sorte que la couche mince intermétallique (110) présente une épaisseur comprise entre 20 et 1000 nm, de préférence entre 200 et 500 nm, et plus préférentiellement de 300 nm.

5. Procédé selon l'une des revendications 1 à 4, dans lequel l'étape de recuit est réalisée par la mise en œuvre d'une opération de recuit global dans laquelle l'ensemble de la couche mince intermétallique (110) est traité thermiquement.

6. Procédé selon la revendication 5, dans lequel la température à laquelle est soumise la pièce d'habillage (10) lors de l'opération de recuit global est comprise entre 200°C et 500°C, et est de préférence sensiblement égale à 300°C, pendant une durée comprise en 30 et 120 minutes, et de préférence de 60 minutes.

7. Procédé selon l'une des revendications 1 à 4, dans lequel l'étape de recuit est réalisée par la mise en œuvre d'une opération de recuit localisé sur une zone prédéterminée (111) de la couche mince intermétallique (110).

8. Procédé selon les revendications 5 et 7, dans lequel l'étape de recuit est réalisée par la mise en œuvre de l'opération de recuit localisé à la suite de l'opération de recuit global.

9. Procédé selon l'une des revendications 7 ou 8, dans lequel l'opération de recuit localisé est réalisée par le biais d'un laser dont le faisceau présente un diamètre compris entre 10 µm et 100 µm.

10. Procédé selon l'une des revendications 7 à 9, dans lequel l'opération de recuit localisé est réalisée par le biais d'un laser configuré pour émettre des impulsions dont la durée est comprise entre 4 ns et 350 ns, de fréquence variable entre 10 kHz et 1 MHz.

11. Procédé selon l'une des revendications 1 à 10, dans lequel l'étape de dépôt de la couche mince intermétallique (110) peut être précédée d'une étape de structuration de surface dans laquelle la surface (112) du substrat (100) est structurée.

12. Procédé selon la revendication 11 et l'une des revendications 7 à 10, dans lequel seule une partie de la surface (112) du substrat (100) est structurée, la partie structurée (113) correspondant à la zone prédéterminée (111) de la couche mince intermétallique (110) soumise à l'opération de recuit localisé.

13. Procédé selon la revendication 11, dans lequel la structuration de surface est réalisée sur l'ensemble de la surface (112) du substrat (100).

14. Procédé selon l'une des revendications 1 à 13, comprenant, à la suite de l'étape de dépôt de couche mince intermétallique (110) et de l'étape de recuit global et/ou localisé, une étape de dépôt d'une couche de protection (120).

15. Procédé selon la revendication 14, dans lequel lors de l'étape de dépôt d'une couche de protection (120), la couche mince intermétallique (110) est recouverte d'un empilement de couches minces diélectriques et/ou d'une couche de polymère translucide.

16. Procédé selon la revendication 15, dans lequel la composition et l'épaisseur des couches minces diélectrique de l'empilement de protection (120) sont spécifiquement choisies pour conserver la couleur originale de la couche mince intermétallique (110) ou pour modifier avantageusement la couleur de la couche mince intermétallique (110) dans une direction choisie.

17. Composant horloger comprenant un substrat (100), **caractérisé en ce que** ledit substrat (100) comprend un revêtement déposé par la mise en œuvre d'un procédé selon l'une des revendications 1 à 16.
